# EUROPEAN PATENT APPLICATION

(11) **EP 1 727 215 A2**
(43) Date of publication of application: **29.11.2006**
(21) Application number: 06252684.3
(22) Date of filing: 23.05.2006
(51) Int. Cl.: H01L 33/00

(54) **Vertical structure semiconductor light emitting device and method for manufacturing the same**

(30) Priority: 23.05.2005 KR 20050043228
(71) Applicant: Samsung Electro-Mechanics Co., Ltd., Suwon, Kyungki-do (KR)
(72) Inventor: Cho, Myong Soo, Suwon, Kyungki-do (KR); Koike, Masayoshi, c/o Samsung Electro-Mech. Co., Suwon, Kyungki-do (KR); Min, Kyeong Ik, 203 Dasom Villa, Seoul (KR); Ahn, Se Hwan, Seoul (KR); Park, Hee Seok, c/o 935-1301 Taeyoung Apt., Suwon, Kyungki-do (KR)
(74) Representative: Powell, Timothy John

(57) **Abstract**

The invention provides a high-quality vertical semiconductor light emitting device having fewer cracks and a manufacturing method thereof. In the vertical semiconductor light emitting device, an Si-Al alloy substrate is prepared. Then a p-type group III-V compound semiconductor layer is formed on the Si-Al alloy substrate. An active layer is formed on the p-type group III-V compound semiconductor layer. Also, an n-type group III-V compound semiconductor layer is formed on the active layer.

## Description

### RELATED APLLICATION

This application claims the benefit of Korean Patent Application No. 2005-0043228 filed on May 23, 2005 in the Korean Intellectual Property Office, the disclosure of which is incorporated herein by reference.

### BACKGROUND OF THE INVENTION

### Field of the Invention

The present invention relates to a compound semiconductor light emitting device and a manufacturing thereof. More particularly, the present invention relates to a vertical group III-V compound semiconductor light emitting device with less defects, such as cracks, and a manufacturing method thereof.

### Description of the Related Art

A GaN-based semiconductor having a composition expressed by AlₓGa_{y}In_{(1-x-y)}N, where 0≤x≤1, 0≤y≤1 and 0≤x+y≤1 is a compound semiconductor material suited to emit blue or ultraviolet ray light, thus utilized in a blue or green light emitting diode. A common GaN-based LED includes a sapphire substrate, an n-type GaN-based semiconductor layer formed on the sapphire substrate, an active layer formed on the n-type GaN-based semiconductor layer, a p-type GaN-based semiconductor layer formed on the active layer and two electrodes (n-electrode and p-electrode). The two electrodes are disposed on one side to face the same direction due to insulating properties of the sapphire substrate used as a growth substrate. In such a planar GaN-based LED, the two electrodes are disposed on upper portions of the device, thus necessitating a large size for the LED device. Also, owing to proximity between the n-electrode and a transparent electrode for spreading current, the planar semiconductor structure is prone to static electricity-induced defects.

Recently, the planar GaN-based LED having the aforesaid defects has given way to a vertical GaN-based LED using a conductive SiC substrate as a growth substrate. However problematically, the SiC substrate is expensive. Another type of vertical GaN-based LED is manufactured by bonding a conductive substrate and removing a sapphire substrate. For example, Korean Patent Application Publication No. 10-2004-0058479 discloses a vertical GaN-based LED including a conductive substrate such as an Si substrate bonded to a GaN-based semiconductor layer via a conductive adhesive layer.

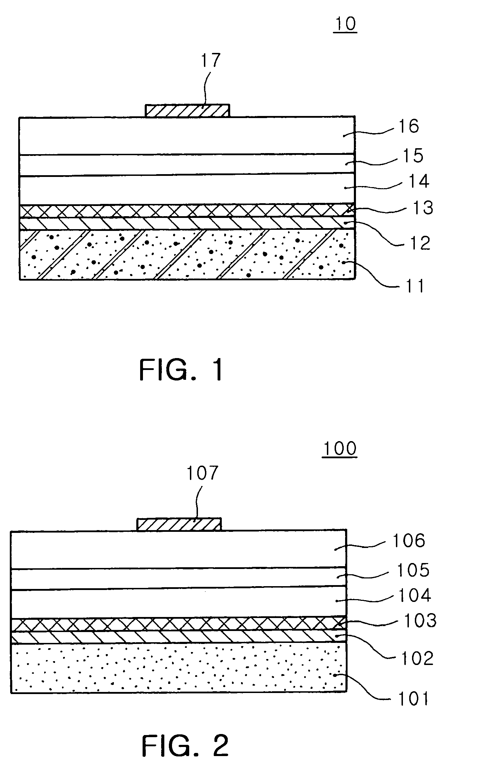

FIG. 1 is a cross-sectional view illustrating a conventional GaN-based light emitting device. Referring to FIG. 1, a vertical GaN-based light emitting device 10 includes a metal reflective layer 13, a p-type GaN-based semiconductor layer 14, an active layer 15, an n-type GaN-based semiconductor layer 16 and an n-electrode 17 stacked one atop another in their order. Also, a conductive substrate 11 is bonded to the metal reflective layer 13 via a conductive adhesive layer 12. For the conductive substrate, the Si substrate having relatively superior thermal conductivity is employed. Compared to the planar GaN-based light emitting device, the vertical GaN-based light emitting device 10 exhibits higher light emitting efficiency, thermostatic properties and electrostatic discharge resistance, with a chip mounted in a smaller area. To manufacture the vertical GaN-based light emitting device 10, GaN-based semiconductor layers 13 to 15 and a metal layer 13 are formed on a growth substrate, i.e., a sapphire substrate (not illustrated). Then, the conductive substrate 11 is bonded to the metal layer 13 via a conductive adhesive layer 12. Thereafter by laser beam irradiation, the sapphire substrate is separated or removed.

However, the separation of the sapphire substrate by laser beam irradiation (hereinafter, "laser lift-off") causes many defects such as cracks in the GaN-based semiconductor layer. This is because thermal expansion coefficient (about 2. 6 ppm/K) of Si of the conductive substrate 11 is much smaller than that (6 to 7 ppm/K) of the sapphire substrate

In a detailed explanation, in case where the conductive substrate 11 is bonded to the metal reflective layer 13 via the conductive adhesive layer 12 at a temperature of about 200□ to 400□ and cooled down to a room temperature, the conductive substrate 11 made of Si shrinks less than the sapphire substrate. Therefore, the sapphire substrate suffers big tensile stress such that the conductive substrate 11 and sapphire substrate are warped. When the sapphire substrate warped by tensile stress is separated by laser beam irradiation, a mechanical impact is applied to the interface between the sapphire substrate and GaN-based semiconductor layer, thereby leaving many cracks on the GaN-based semiconductor layer. Cracks generated in separating of the growth substrate may occur in a manufacturing process of not only the GaN-based semiconductor LED but also of a vertical light emitting device using the group III-V compound semiconductor such as an AlGaInP-based semiconductor and AlGaAs-based semiconductor.

### SUMMARY OF THE INVENTION

The present invention has been made to solve the foregoing problems of the prior art and it is therefore an object of the present invention to provide a vertical semiconductor light emitting device having fewer cracks.

It is another object of the invention to provide a method for manufacturing a vertical semiconductor light emitting device, by which cracks can be reduced in separating of a growth substrate.

According to an aspect of the invention for realizing the object, there is provided a vertical semiconductor light emitting device comprising: an Si-Al alloy substrate; a p-type group III-V compound semiconductor layer formed on the Si-Al alloy substrate; an active layer formed on the p-type group III-V compound semiconductor layer; and an n-type group III-V compound semiconductor layer.

Preferably, the Si-Al alloy substrate contains Si in the range of 50 wt% to 90 wt%. More preferably, the Si-Al alloy substrate contains Si in the range of 60 wt% to 80 wt%. Much more preferably, the Si-Al alloy substrate contains Si in the range of 70 wt% to 75wt%.

According to a preferred embodiment of the invention, the vertical semiconductor light emitting device further comprises a conductive adhesive layer between the Si-Al alloy substrate and the p-type group III-V compound semiconductor layer. Preferably, the conductive adhesive layer comprises Au. The conductive adhesive layer comprises an eutectic metal selected from a group consisting of Au/Ge, Au/In, Au/Sn and Pb-Sn. Additionally, the conductive adhesive layer comprises a conductive organic material.

According to a preferred embodiment of the invention, the vertical semiconductor light emitting device further comprises a metal reflective layer formed between the conductive adhesive layer and the p-type group III-V compound semiconductor layer. Preferably, the metal reflective layer comprises a metal selected from a group consisting of Au, Ag, Al, Rh and alloys thereof.

According to one embodiment of the invention, the p- and n-type group III-V compound semiconductors and the active layer comprise a semiconductor material having a composition expressed by AlₓGa_{y}In_{(1-x-y)}N, where 0≤x≤1, 0≤y≤1 and 0≤x+y≤1. According to another embodiment of the invention, the p- and n-type group III-V compound semiconductors and the active layer comprise a semiconductor material having a composition expressed by AlₓGa_{y}In_{(1-x-y)}P, where 0≤x≤1, 0≤y≤1 and 0≤x+y≤1. According to further another embodiment of the invention, the p- and n-type group III-V compound semiconductors and the active layer comprise a semiconductor material having a composition expressed by AlₓGa₍₁₋ₓ₎As, where 0≤x≤1.

According to another aspect of the invention for realizing the object, there is provided a method for manufacturing a vertical semiconductor light emitting device comprising steps of:
forming an n-type group III-V compound semiconductor layer, an active layer and a p-type group III-V compound semiconductor layer sequentially on a growth substrate;
bonding an Si-Al alloy substrate to the p-type group III-V compound semiconductor; and
removing the growth substrate from the group III-V compound semiconductor layer.

Preferably, the Si-Al alloy substrate contains Si in the range of 50 wt% to 90 wt%. More preferably, the Si-Al alloy substrate contains Si in the range of 60 wt% to 80 wt%. Much more preferably, the Si-Al alloy substrate contains Si in the range of 70 wt% to 75 wt%.

According to a preferred embodiment of the invention, the Si-Al alloy substrate bonding step is carried out via a conductive adhesive layer. At this time, preferably, the conductive adhesive layer comprises Au. The conductive adhesive layer comprises an eutectic metal selected from a group consisting of Au/Ge, Au/In, Au/Sn and Pb/Sn. Alternatively, the conductive adhesive layer comprises a conductive organic material.

According to another preferred embodiment of the invention, the method further comprises: between the p-type group III-V compound semiconductor layer forming step and the Si-Al alloy substrate bonding step, forming a metal reflective layer on the p-type group III-V compound semiconductor layer. The metal reflective layer is made of one selected from a group consisting of Au, Al, Ag and Rh.

Alternatively, the Si-Al alloy substrate bonding step comprises directly bonding the Si-Al alloy substrate to the p-type group III-V compound semiconductor layer. At this time, the Si-Al alloy substrate is bonded to the p-type group III-V compound semiconductor layer without additional intermediate layer.

According one embodiment of the invention, the p- and n-type group III-V compound semiconductor layers and the active layer comprise a semiconductor material having a composition expressed by AlₓGa_{y}In_{(1-x-y)}N, where 0≤x≤1, 0≤y≤1 and 0≤x+y≤1, and wherein the growth substrate is a sapphire substrate. According to another embodiment of the invention, the p- and n-type group III-V compound semiconductor layer and the active layer comprise a semiconductor material having a composition expressed by AlₓGa_{y}In_{(1-x-y)}P, where 0≤x≤1, 0≤y≤1 and 0≤x+y≤1, and wherein the growth substrate is a GaAs substrate. According to further embodiment of the invention, the p- and n-type group III-V compound semiconductor layer and the active layer comprise a semiconductor material having a composition expressed by AlₓGa₁₋ₓAs, where 0≤x≤1, and wherein the growth substrate is a GaAs substrate.

According to further another preferred embodiment of the invention, the growth substrate removing step is carried out by laser lift-off.

### BRIEF DESCRIPTION OF THE DRAWINGS

The above and other objects, features and other advantages of the present invention will be more clearly understood from the following detailed description taken in conjunction with the accompanying drawings, in which:

FIG. 1 is a cross-sectional view illustrating an example of a conventional light emitting device;

FIG. 2 is a cross-sectional view illustrating a vertical semiconductor light emitting device according to one embodiment of the invention;

FIGs. 3 to 8 are cross-sectional views for explaining a method for manufacturing a vertical semiconductor light emitting device according to one embodiment of the invention;

FIG. 9 is an optical microscopic view illustrating an exposed surface of an n-type GaN-based semiconductor layer after removing of a sapphire substrate in a manufacturing process according to one embodiment of the invention; and

FIG. 10 is an optical microscopic view illustrating an exposed surface of an n-type GaN-based semiconductor layer after removing of a sapphire substrate in a manufacturing process of the prior art.

### DETAILED DESCRIPTION OF THE PREFERRED EMBODIMENT

The present invention now will be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the shapes and dimensions may be exaggerated for clarity, and the same reference signals are used to designate the same or similar components throughout.

FIG. 2 is a cross-sectional view illustrating a vertical semiconductor light emitting device according to one embodiment of the invention. Referring to FIG. 2, the vertical semiconductor light emitting device 100 includes a substrate 101 made of an alloy of Si-Al (hereinafter, 'Si-Al alloy substrate'). Also, a conductive adhesive layer 102, a metal reflective layer 103, a p-type semiconductor layer 104, an active layer 105 and an n-type semiconductor layer 106 are stacked sequentially on the Si-Al alloy substrate 101. The p- and n-type semiconductor layers 104, 106 and the active layer 105 constituting a light emitting structure are made of a GaN-based semiconductor material having a composition expressed by AlₓGa_{y}In_{(1-x-y)}N, where 0≤x≤1, 0≤y≤1 and 0≤x+y≤1. Further, an n-electrode 107 is formed on the n-type semiconductor layer 106.

Unlike a conventional device, the vertical semiconductor light emitting device 100 of the invention employs the conductive Si-Al alloy substrate 101. The Si-Al alloy is greatly advantageous in terms of thermal expansion coefficient, thermal conductivity, mechanical processability and price. That is, as shown in FIG. 1 below, the Si-Al alloy has thermal expansion coefficient variously adjusted in accordance with the composition ratio of Si and Al in the alloy.

**Table 1**

| Composition ratio | Thermal expansion coefficient at 25□ (ppm/K) |
|---|---|
| 80 wt% Si - Al | 5 |
| 70 wt% Si - Al | 7 |
| 60 wt% Si - Al | 9 |
| 50 wt% Si - Al | 11 |
| 42 wt% Si - Al | 13 |
| 28 wt% Si - Al | 16 |

As shown in FIG. 1, in case where the Si-Al alloy contains 60 wt% to 80 wt% Si, thermal expansion coefficient of the Si-Al is about 5 ppm/K to 9 ppm/K at a temperature of 25□. Such thermal expansion coefficient is very similar to that (about 6 ppm/K to 7 ppm/K) of a sapphire substrate. Therefore, the vertical semiconductor light emitting device manufactured via the Si-Al alloy substrate containing 60 wt% to 80 wt% Si significantly inhibits warping of the substrate and cracks of the light emitting structure which occurs in bonding of the conductive substrate and separating of the sapphire substrate via laser irradiation according to the prior art. Consequently, this leads to a high-quality vertical semiconductor light emitting device reduced in defects such as cracks.

As a result of the experiment, the inventors have obtained the vertical semiconductor light emitting device having considerably fewer cracks than the conventional light emitting device (see FIG. 1) even in case where the Si-Al alloy substrate 101 contains 50 wt% to 90 wt% Si. However, to suppress cracks further, thermal expansion coefficient of the Si-Al alloy substrate preferably approximates that of the sapphire substrate. Preferably, the Si-Al alloy substrate 101 contains 60 to 80 wt% Si. More preferably, the Si-Al alloy substrate 101 contains 70 to 75 wt% Si.

Also, thermal conductivity of the Si-Al alloy substrate 101 is 120 to 180 W/m · K, exhibiting excellent heat release properties like an Si substrate. Moreover, the Si-Al alloy substrate is easily manufacturable through fusion of Si and Al at a high temperature, thereby obtaining the Si-Al alloy substrate easily at a low price. Consequently, the vertical semiconductor light emitting device 100 manufactured via the Si-Al alloy substrate 101 demonstrates superior heat release properties, also requiring less manufacturing costs than the conventional device. In addition, due to insignificant difference in thermal expansion coefficient between the Si-Al alloy substrate 101 and the light emitting structure 104, 105 and 106 made of GaN-based semiconductors, a bonding surface of the light emitting device substrate is not impaired by die bonding or wire bonding at a high temperature of 280□ or more in case of a packaging process. This relaxes a process standard of the die bonding, and thus enhances yield for packages.

Referring to FIG. 2, a metal layer 103 inserted between the conductive adhesive layer 102 and the p-type semiconductor layer 104 reflects light incident from the semiconductor layer upward, thereby increasing brightness further. Preferably, the metal reflective layer is made of one selected from a group consisting of Au, Ag, Al, Rh and alloys thereof. However, the metal reflective layer 103 is not an essential constituent of the invention and optionally omissible.

As stated later, the conductive adhesive layer 102 serves to bond the Si-Al alloy substrate 101 to the light emitting structure. Preferably, the conductive adhesive layer is made of Au. Alternatively, the conductive adhesive layer 102 is made of an eutectic metal selected from a group consisting of Au/Ge, Au/In, Au/Sn and Pb-Sn. Alternatively, a conductive organic material may be adopted for the conductive adhesive layer 102.

In the embodiment of the invention, the light emitting device includes the conductive adhesive layer 102. But alternatively, the Si-Al alloy substrate 101 may be directly bonded to the p-type semiconductor layer 104 without the conductive adhesive layer 102.

The embodiment of the invention describes a GaN-based semiconductor light emitting device employing a semiconductor material having a composition expressed by AlₓGa_{y}In_{(1-x-y)}N. The invention is applicable to a vertical light emitting device using other group III-V compound semiconductor materials. For example, the p- and n-type semiconductor layers 104 and 106 and the active layer 105 may be made of a semiconductor material having a composition expressed by AlₓGa_{y}In_{(1-x-y)}P, where 0≤x≤1, 0≤y≤1 and 0≤x+y≤1. In another embodiment, the p- and n-type semiconductor layers 104 and 106 and the active layer 105 are made of a semiconductor material having a composition expressed by AlₓGa ₍₁₋ₓ₎As where 0≤x≤1. In the embodiments of the invention, the Si-Al alloy substrate is used as a conductive substrate.

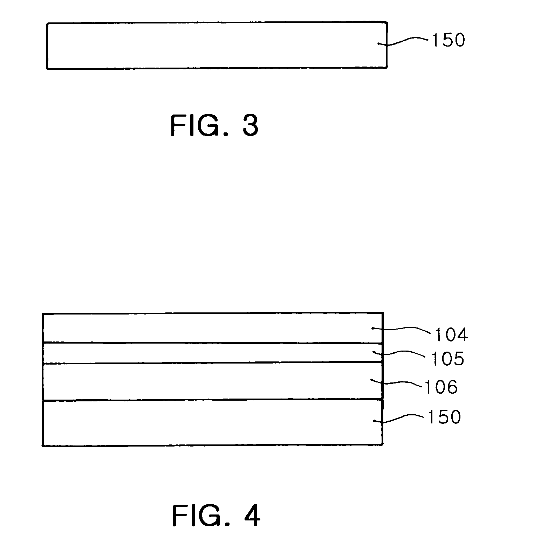

An explanation will be given hereunder about a method for manufacturing a vertical semiconductor light emitting device according to the preferred embodiment of the invention with reference to FIGs. 3 to 8. First, referring to FIG. 3, a sapphire substrate 150 is prepared as a growth substrate. Then, as shown in FIG. 4, an n-type semiconductor layer 106, an active layer 105 and a p-type semiconductor layer 104 are grown sequentially on the sapphire substrate 150. The n-type semiconductor layer is made of a semiconductor material having a composition expressed by AlₓGa_{y}In_{(1-x-y)}N.

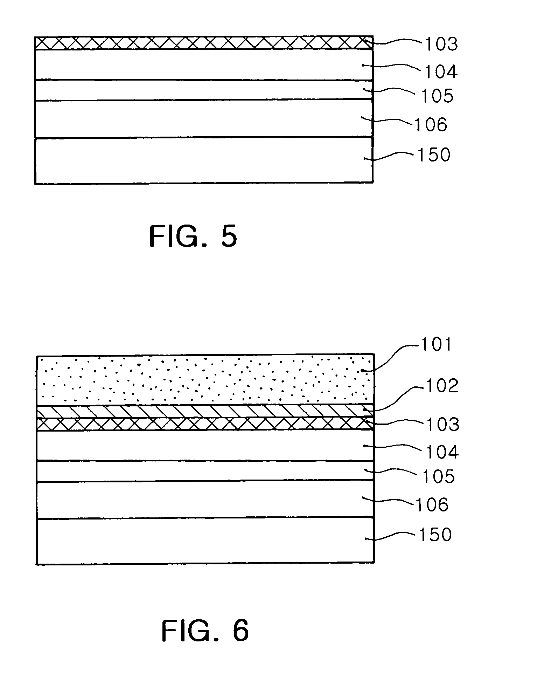

Next, as shown in FIG. 5, a metal reflective layer 103 is formed on the p-type semiconductor layer 104. The metal reflective layer is made of a high reflective metal, for example, one selected from a group consisting of Au, Al, Ag and Rh.

Thereafter, as shown in FIG. 6, a conductive adhesive layer 102 is used to bond an Si-Al alloy substrate 101 to the metal reflective layer 103. Preferably, the conductive adhesive layer 102 is made of Au. The conductive adhesive layer 102 may be made of an eutectic metal selected from a group consisting of Au/Ge, Au/In, Au/Sn and Pb/Sn. Alternatively, a conductive organic material may be adopted for the conductive adhesive layer 102. The temperature for bonding the Si-Al alloy substrate 101 is varied by types of the conductive adhesive layer 102. For example, the conductive adhesive layer 102 made of Au allows the Si-Ai alloy substrate 101 to be bonded at a high temperature of 300□ to 400□.

The Si-Al alloy substrate 101 is a conductive substrate, serving as a supporting substrate when the sapphire substrate 150 is removed in a later process. As stated above, the Si-Al alloy substrate 101 contains 50 wt% to 90 wt% Si. More preferably, the Si-Al alloy substrate 101 contains 60 wt% to 80 wt% Si. Much more preferably, the Si-Al alloy substrate 101 contains 70 wt% to 75 wt% Si.

In this embodiment of the invention, the conductive adhesive layer 102 is used to bond the Si-Al alloy substrate 101. But alternatively, the Si-Al alloy substrate 101 may be directly bonded to the p-type group III-V compound semiconductor layer 104. For example, to accomplish direct bonding, the p-type semiconductor layer 104 and the Si-Al alloy substrate 101 are heated at a temperature of 400□ to 500□ and the Si-Al alloy substrate 101 is compressed onto the p-type semiconductor layer 104. In this case, the Si-Al alloy substrate 101 and the p-type group III-V compound semiconductor layer 104 are bonded without additional intermediate layer.

Owing to inconsiderable difference in thermal expansion coefficient between the Si-Al alloy substrate 101 and the sapphire substrate 150, bonding of the Si-Al alloy substrate 101 even at a high temperature of 300□ or more as described above does not result in warping of the substrate as in the prior art. That is, even in case where the Si-Al alloy substrate 101 is bonded and then cooled down to a room temperature, big tensile strength is not applied to the sapphire substrate 150.

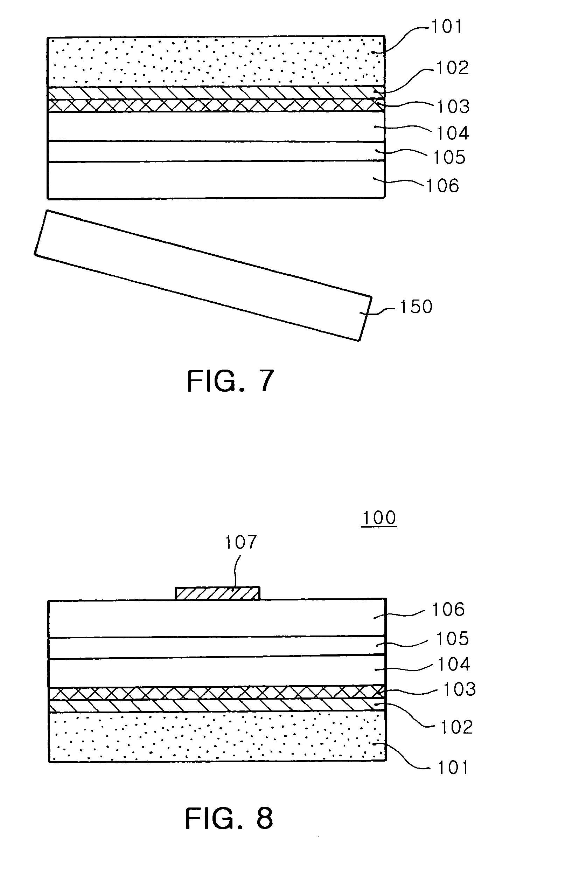

Then, as depicted in FIG. 7, laser beam is irradiated to an interface between the sapphire substrate 150 and the n-type semiconductor layer 106 (via laser lift-off) to remove the sapphire substrate 150 from the n-type semiconductor layer 106. As described earlier, since the substrate does not bend even after being bonded to the Si-Al alloy substrate, the n-type semiconductor layer 106 does not suffer defects such as cracks even though the sapphire substrate 150 is removed.

Next, as shown in FIG. 8, an n-electrode 107 is formed on the n-type semiconductor layer 106 exposed by removing the sapphire substrate 150. This allows the vertical semiconductor light emitting device 100 according to the preferred embodiment of the invention. In this embodiment of the invention, the sapphire substrate 150 was used as a growth substrate and a semiconductor material having a composition expressed by AlₓGa_{y}In_{(1-x-y)}N, where 0≤x≤1, 0≤y≤1, 0≤x+y≤1 was used as a light emitting structure. But the invention is not limited thereto.

For example, in another embodiment of the invention, a GaAs substrate may be employed in place of the sapphire substrate 150 as the growth substrate. Also, a semiconductor material having a composition expressed by AlₓGa_{y}In_{(1-x-y)}P, where 0≤x≤1, 0≤y≤1 and 0≤x+y≤1 may be used in substitute for the semiconductor material having a composition expressed by AlₓGa_{y}In_{(1-x-y)}N, where 0≤x≤1, 0≤y≤1, and 0≤x+y≤1 to constitute the light emitting structure (p- and n-type semiconductor layers and active layer). In further another embodiment of the invention, the GaAs substrate may be used in place of the sapphire substrate 150 and a semiconductor material having a composition expressed by AlₓGa₁₋ₓAs, where 0≤x≤1 is used to constitute the light emitting structure. But in the embodiments of the invention, the Si-Al alloy substrate 101 is adopted as a conductive substrate to be bonded to the light emitting structure. Thermal expansion coefficient of the GaAs substrate is about 6 ppm/K to 7 ppm/K, and thus the Si-Al alloy substrate (having thermal expansion coefficient similar to that of GaAs substrate) is utilized instead of the conventional Si substrate as the conductive substrate. This prevents warping of the substrate in bonding of the Si-Al alloy substrate or crack occurrence in removing of the sapphire substrate.

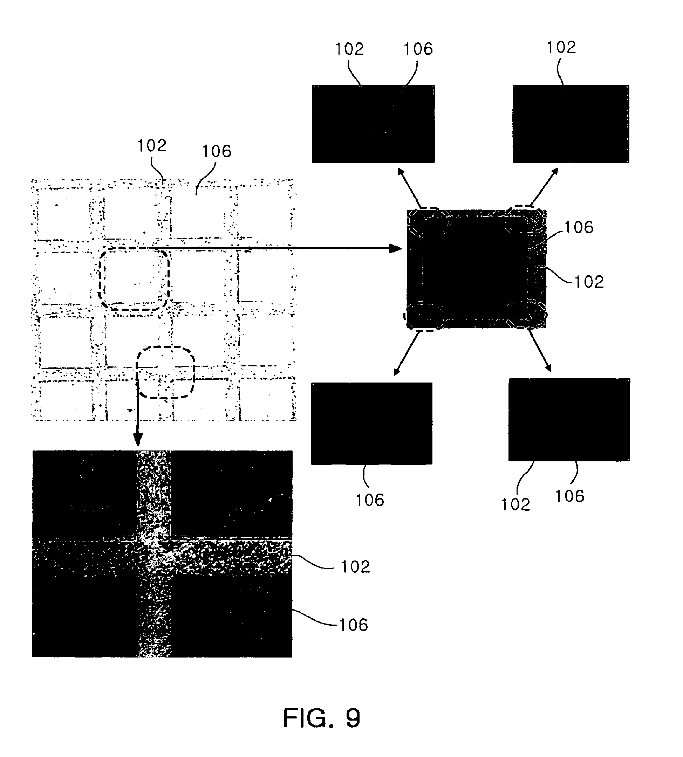

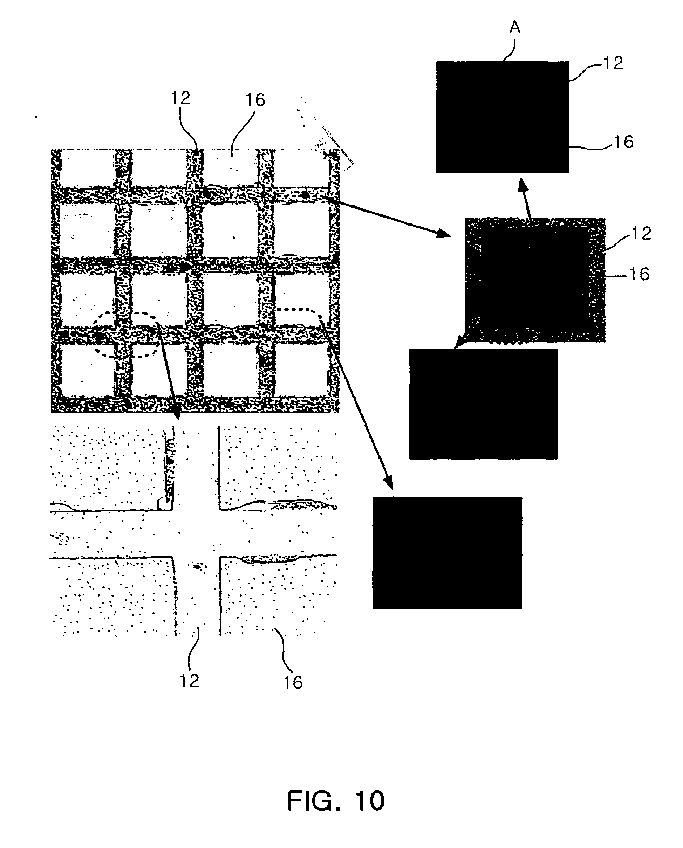

To confirm effects of crack reduction according to the invention, the inventors conducted bonding of the Si substrate (see reference numeral 11 of FIG. 1) and removal of the sapphire substrate (according to the prior art). Also, the inventors performed bonding of the Si-Al alloy substrate (see FIG. 101 of FIG. 2) and removal of the sapphire substrate (according to the present invention). FIGs. 9 and 10 are pictures illustrating a surface of the n-type semiconductor layer after bonding of the conductive substrate and removing of the sapphire substrate.

FIG. 9 is an optical microscopic view illustrating an exposed surface of the n-type GaN layer 106 after bonding of the Si-Al alloy substrate to the p-type GaN layer and removing of the sapphire substrate according to the invention. FIG. 10 is an optical microscopic view illustrating an exposed surface of the n-type GaN layer 16 after bonding of the Si substrate to the p-type GaN layer and removing of the sapphire substrate according to the prior art. The sapphire substrates were removed via laser lift-off. As shown in FIGs. 9 and 10, the n-type GaN layer 106, 16 is separated for individual devices, while the conductive adhesive layer 102, 12 enveloping the n-type GaN layer 106, 16 is not separated for individual devices.

As shown in FIG. 9, the Si-Al alloy substrate employed leads to fewer cracks in the n-type GaN layer 106. Meanwhile, as shown in FIG. 10, the Si substrate used results in a considerable number of cracks, especially at corners, in the n-type GaN layer 16. In this fashion, substrate bonding and removal conducted using the Si-Al alloy substrate can dramatically reduce the number of cracks.

As set forth above, according to the invention, an Si-Al alloy substrate is used for a conductive substrate to obtain a high-quality vertical semiconductor light emitting device with fewer cracks. Also, due to excellent thermal conductivity of the Si-Al alloy substrate, the vertical light emitting device of the invention exhibits superior heat release properties.

Furthermore, a temperature standard for die bonding or wire bonding is relaxed in a packaging process of the light emitting device owing to minor difference in thermal expansion coefficient between a light emitting structure made of a compound semiconductor and an Si-Al alloy substrate. This improves yield for light emitting device packages. In addition, the Si-Al alloy substrate is easily obtainable at a low price, thereby advantageously reducing manufacturing costs of the light emitting device.

While the present invention has been shown and described in connection with the preferred embodiments, it will be apparent to those skilled in the art that modifications and variations can be made without departing from the spirit and scope of the invention as defined by the appended claims.

## Claims

1. A vertical semiconductor light emitting device comprising:
an Si-Al alloy substrate;
a p-type group III-V compound semiconductor layer formed on the Si-Al alloy substrate;
an active layer formed on the p-type group III-V compound semiconductor layer; and
an n-type group III-V compound semiconductor layer.

2. The vertical semiconductor light emitting device according to claim 1, wherein the Si-Al alloy substrate contains Si in the range of 50 wt% to 90 wt%.

3. The vertical semiconductor light emitting device according to claim 1, wherein the Si-Al alloy substrate contains Si in the range of 60 wt% to 80 wt%.

4. The vertical semiconductor light emitting device according to claim 1, wherein the Si-Al alloy substrate contains Si in the range of 70 wt% to 75wt%.

5. The vertical semiconductor light emitting device according to claim 1, further comprising a conductive adhesive layer between the Si-Al alloy substrate and the p-type group III-V compound semiconductor layer.

6. The vertical semiconductor light emitting device according to claim 5, wherein the conductive adhesive layer comprises Au.

7. The vertical semiconductor light emitting device according to claim 5, wherein the conductive adhesive layer comprises one selected from a group consisting of Au/Ge, Au/In, Au/Sn and Pb-Sn.

8. The vertical semiconductor light emitting device according to claim 5, wherein the conductive adhesive layer comprises a conductive organic material.

9. The vertical semiconductor light emitting device according to claim 5, further comprising a metal reflective layer formed between the conductive adhesive layer and the p-type group III-V compound semiconductor layer

10. The vertical semiconductor light emitting device according to claim 9, wherein the metal reflective layer comprises a metal selected from a group consisting of Au, Ag, Al, Rh and alloys thereof.

11. The vertical semiconductor light emitting device according to claim 1, wherein the p- and n-type group III-V compound semiconductors and the active layer comprise a semiconductor material having a composition expressed by AlₓGa_{y}In_{(1-x-y)}N, where 0≤x≤1, 0≤y≤1 and 0≤x+y≤1.

12. The vertical semiconductor light emitting device according to claim 1, wherein the p- and n-type group III-V compound semiconductors and the active layer comprise a semiconductor material having a composition expressed by AlₓGa_{y}In_{(1-x-y)}P, where 0≤x≤1, 0≤y≤1 and 0≤x+y≤1.

13. The vertical semiconductor light emitting device according to claim 1, wherein the p- and n-type group III-V compound semiconductors and the active layer comprise a semiconductor material having a composition expressed by AlₓGa₍₁₋ₓ₎As, where 0≤x≤1.

14. A method for manufacturing a vertical semiconductor light emitting device comprising steps of:
forming an n-type group III-V compound semiconductor layer, an active layer and a p-type group III-V compound semiconductor layer sequentially on a growth substrate;
bonding an Si-Al alloy substrate to the p-type group III-V compound semiconductor; and
removing the growth substrate from the group III-V compound semiconductor layer.

15. The method according to claim 14, wherein the Si-Al alloy substrate contains Si in the range of 50 wt% to 90 wt%.

16. The method according to claim 14, wherein the Si-Al alloy substrate contains Si in the range of 60 wt% to 80 wt%.

17. The method according to claim 14, wherein the Si-Al alloy substrate contains Si in the range of 70 wt% to 75 wt%.

18. The method according to claim 14, wherein the Si-Al alloy substrate bonding step is carried out via a conductive adhesive layer.

19. The method according to claim 18, wherein the conductive adhesive layer comprises Au.

20. The method according to claim 18, wherein the conductive adhesive layer comprises one selected from a group consisting of Au/Ge, Au/In, Au/Sn and Pb/Sn.

21. The method according to claim 18, wherein the conductive adhesive layer comprises a conductive organic material.

22. The method according to claim 14, further comprising:
between the p-type group III-V compound semiconductor layer forming step and the Si-Al alloy substrate bonding step, forming a metal reflective layer on the p-type group III-V compound semiconductor layer.

23. The method according to claim 14, wherein the Si-Al alloy substrate bonding step comprises directly bonding the Si-Al alloy substrate to the p-type group III-V compound semiconductor layer.

24. The method according to claim 14, wherein the p- and n-type group III-V compound semiconductor layers and the active layer comprise a semiconductor material having a composition expressed by AlₓGa_{y}In_{(1-x-y})N, where 0≤x≤1, 0≤y≤1 and 0≤x+y≤1, and
wherein the growth substrate is a sapphire substrate.

25. The method according to claim 14, wherein the p- and n-type group III-V compound semiconductor layer and the active layer comprise a semiconductor material having a composition expressed by AlₓGa_{y}In_{(1-x-y)}P, where 0≤x≤1, 0≤y≤1 and 0≤x+y≤1, and
wherein the growth substrate is a GaAs substrate.

26. The method according to claim 14, wherein the p- and n-type group III-V compound semiconductor layer and the active layer comprise a semiconductor material having a composition expressed by AlₓGa₁₋ₓAs, where 0≤x≤1, and
wherein the growth substrate is a GaAs substrate.

27. The method according to claim 14, wherein the growth substrate removing step is carried out by laser lift-off.
